# EUROPEAN PATENT APPLICATION

(11) **EP 4 325 132 A1**
(43) Date of publication of application: **21.02.2024**
(21) Application number: 22793506.1
(22) Date of filing: 02.08.2022
(51) Int. Cl.: F24F 5/00, F24F 13/30, F24F 13/22, F24F 13/28, H05K 7/20

(54) **FAN-ARRAY AIR HANDLING UNIT**

(30) Priority: 05.07.2022 CN 202210785323
(71) Applicant: AIRSYS REFRIGERATION ENGINEERING TECHNOLOGY (BEIJING) CO., LTD., Beijing 100043 (CN)
(72) Inventor: CHEN, Yunshui, Beijing 100043 (CN); FANG, Xuming, Beijing 100043 (CN)
(74) Representative: V.O.
(86) International application number: PCT/CN2022/109739
(87) International publication number: WO 2024/007397

(57) **Abstract**

Disclosed is an air wall type air conditioning unit. The air wall type air conditioning unit includes a plurality of refrigeration modules distributed in a vertical direction, each refrigeration module includes: a housing, which defines a cavity, and an air inlet and an air outlet are further disposed on the housing; a heat exchanger, which is located in the cavity and configured for cooling air; and a draught fan, which is located in the cavity and configured for conveying the cooled air to equipment to be cooled; wherein, in the direction from the air inlet to the air outlet, the heat exchanger and the draught fan are distributed in sequence. According to the air wall type air conditioning unit of the technical solution of the invention, modular design is adopted, meanwhile, the number of the refrigeration modules can be configured according to actual application scenes, thus transportation is facilitated.

## Description

### Cross-Reference to Related Application

This application claims priority to a prior application No. 202210785323.0, filed on July 5, 2022 and entitled "Air Wall Type Air Conditioning Unit".

### Technical Field

The invention relates to the technical field of refrigeration, in particular to an air wall type air conditioning unit.

### Background

With the landing of information concepts such as the Internet of Things, 5G and edge computing, various storage and computing devices have surged by geometric multiples, which makes a scale of data centers continue to expand. Consequently, in addition to more efficient processing capacity, there is soaring energy consumption. At present, policies for defining the PUE of the data centers are gradually tightened in front-line cities such as Beijing, Shanghai and Guangzhou, the new construction and the renovation of the data centers face severe challenges, and in the face of the condition, as a key part of the PUE of the data centers, the energy conservation of a cooling system is bound to face great challenges. The air wall air conditioning technology has become an important breakthrough direction for energy-saving application of the data centers. The air wall air conditioning technology is an energy-saving technology which utilizes a natural cold source or chilled water to provide a cold source, and is mainly characterized in that an air wall air conditioning system consisting of an air wall control system, a fan set and a surface air cooler can be used for cooling a server with high-density heat of the data center.

In a prior art, a single air wall unit is of an integrated structure, which is large in size, and if a complete machine transportation mode is adopted, large hoisting equipment is required for loading and unloading, so that the cost is high; and if it needs to be installed on a high floor, the air wall unit cannot be transported by an industrial elevator, and needs to be transported to the high floor by the large hoisting equipment, meanwhile, a room body structure needs to be dismantled, so that it is difficult to operate.

### Summary

Some embodiments of the invention mainly aims to provide an air wall type air conditioning unit, for solving a problem of transportation inconvenience caused by large size of an air wall type air conditioning unit in the prior art.

According to an aspect of the invention, there is provided an air wall type air conditioning unit, which includes a plurality of refrigeration modules distributed in the vertical direction. Each refrigeration module includes: a housing, which defines a cavity, and an air inlet and an air outlet are further formed on the housing; a heat exchanger, which is located in the cavity and configured for cooling air; and a draught fan, which is located in the cavity and configured for conveying the cooled air to equipment to be cooled; where, in a direction from the air inlet to the air outlet, the heat exchanger and the draught fan are distributed in sequence.

In some embodiments, the each refrigeration module further includes: a water pan, which is located below the heat exchanger; and a drainage structure, which is disposed in the cavity and located on a side of the heat exchanger, the water pan communicates with the drainage structure, and drainage structures of two adjacent refrigeration modules communicate through a connecting pipe.

In some embodiments, the water pan is provided with a collecting groove. The drainage structure includes: a first drainage pipe, connected with the water pan and located above the water pan, and an end of the first drainage pipe extends into the collecting groove; and a second drainage pipe, which communicates with the collecting groove; wherein, a second drainage pipe of the refrigeration module located above in two adjacent refrigeration modules communicates with an end of the connecting pipe, and a first drainage pipe of the refrigeration module located below in the two adjacent refrigeration modules communicates with the other end of the connecting pipe, so as to communicate two drainage structures of the two adjacent refrigeration modules.

In some embodiments, the drainage structure further includes: a support piece, which includes a bottom plate and two side plates connected with the bottom plate, an assembly through hole allowing the first drainage pipe to pass through is formed in the bottom plate, and the side plates are connected with the collecting groove.

In some embodiments, the housing of the each refrigeration module is provided with a first side and a second side which are oppositely disposed, the first side is provided with a protrusion, and the second side is provided with a groove which is matched with the protrusion in a clamping manner, so that two adjacent refrigeration modules are matched in a clamping manner.

In some embodiments, the housing includes a supporting frame, a base connected with the supporting frame, as well as a top cover and circumferential side walls connected with the supporting frame. The base is disposed opposite to the top cover, a lower surface of the base protrudes from a lower surface of the supporting frame to form the protrusion, and the top cover and the supporting frame define the groove. When the air wall type air conditioning unit is assembled, a base of a refrigeration module located above in the two adjacent refrigeration modules is placed in a groove of a refrigeration module located below.

In some embodiments, the inner wall face of the housing is provided with an installation groove communicating with the cavity, and the refrigeration module further includes an electric control box located in the installation groove, and a door plate of the electric control box is flush with the inner wall face of the housing.

In some embodiments, the heat exchanger includes a plurality of heat exchange tubes which communicate with each other, and the plurality of heat exchange tubes form a "W"-shaped structure; or, the plurality of heat exchange tubes form a "V" shape.

In some embodiments, each refrigeration module further includes a flow equalizing plate disposed between the heat exchanger and the draught fan, a shape of the flow equalizing plate is matched with at least part of a shape of the heat exchanger, and a plurality of through holes are formed in the flow equalizing plate and the through holes are evenly distributed.

In some embodiments, the air wall type air-conditioning unit further includes a foundation capable of supporting the plurality of refrigeration modules. The each refrigeration module further includes: an air valve, which located at the air outlet, and is able to control the cavity to be communicated or disconnected with the external environment; and an air filter, which is located at the air inlet to filter incoming air.

By adoption of the technical solution of the invention, in each refrigeration module, outside air enters the cavity through the air inlet to exchange heat with the heat exchanger, and the draught fan can provide driving force to blow the cooled air to the air outlet and deliver it to the equipment to be cooled. The plurality of refrigeration modules are detachably connected in the vertical direction, so that different numbers of refrigeration modules can be disposed in the vertical direction according to actual needs; meanwhile, the air wall type air conditioning unit can be split into a plurality of refrigeration modules with smaller volumes, thus transportation and carrying are facilitated, the problems of small traffic space such as elevators and passages and difficult carrying of the air wall type air conditioning unit re solved, and the installation requirements of different machine rooms can be met; in addition, the modular design makes parts miniaturized and batched, which is beneficial to batch processing of all parts and assembly of the whole machine.

### Brief Description of the Drawings

The drawings, which form a part hereof, serve to provide a further understanding of the invention, and illustrative embodiments of the invention and descriptions thereof serve to explain the invention and are not to be construed as unduly limiting the invention. In the drawings:
Fig. 1 illustrates a schematic structure diagram of an air wall type air conditioning unit according to an embodiment of the invention.
Fig. 2 illustrates a schematic structure diagram of interior of an air wall type air conditioning unit according to Fig. 1 (a housing is not shown).
Fig. 3 illustrates a schematic structure diagram of a refrigeration module of an air wall type air conditioning unit in Fig. 2 (the direction of the refrigeration module is that after the refrigeration module of Fig. 1 rotates 90 ° clockwise).
Fig. 4 illustrates an enlarged view at A of an air wall type air conditioning unit in Fig. 2.
Fig. 5 illustrates a schematic diagram of connection between a water pan and a drainage structure of a refrigeration module in Fig. 3.
Fig. 6 illustrates a schematic structure diagram of an air wall type air conditioning unit according to another embodiment of the invention.
Fig. 7 illustrates a schematic structure diagram of an air wall type air conditioning unit according to still another embodiment of the invention.
Fig. 8 illustrates a schematic structure diagram of an air wall type air conditioning unit according to yet another embodiment of the invention.

Where, the above-mentioned drawings include the following reference numerals:
100. Refrigeration module; 101. Air filter; 102. Heat exchanger; 1021. Heat exchange tube; 103. Flow equalizing plate; 104. Draught fan; 105. Air valve; 106. Electric control box; 107. Door plate; 108. Circumferential side wall; 112. Base; 113. Top cover; 115. Air inlet; 116. Air outlet; 117. Drainage structure; 121. First drainage pipe; 122. Support piece; 1221. Bottom plate; 1222. Side plate; 1223. Assembly through hole; 1226. Connecting plate; 1227. Avoidance space; 123. Water catch bow; 124. Second drainage pipe; 125. Connecting pipe; 201. Supporting frame; 2011. Cross beam; 2012. Longitudinal beam; 203. Groove; 205. Housing; 2051. Installation groove; 206. Cavity; 220. Water pan; and 900. Foundation.

### Detailed Description of the Embodiments

It is to be noted that the embodiments and features in the embodiments of the present invention may be combined with each other without conflict. The invention will now be described in detail with reference to the accompanying drawings and the embodiments.

It is to be noted that, due to the structural characteristics of the product, a single air wall unit is large in size, in the aspect of transportation, if a complete machine transportation mode is adopted, large hoisting equipment is required for loading and unloading of the unit, so that the cost is high; and if it needs to be installed on a high floor, a transitional air wall cannot be transported by an industrial elevator, and needs to be transported to the high floor by the large hoisting equipment, and meanwhile, a room body structure needs to be dismantled, so that the difficulty of operation is very high. In addition, in the aspect of installation, many manufacturers will deliver parts to installation site of a customer, resulting in scattered distribution of parts on the installation site, and employees need to look for the parts everywhere, which leads to the phenomenon that parts are easily lost, so that the management difficulty of the construction site increases. If the parts are delivered to the site for assembly, there is hidden danger of product quality control failure due to problems such as staff skills and site management, resulting in quality problems such as the inability to guarantee product consistency and low customer satisfaction. The single air wall unit in the prior art is inconvenient to install and transport, therefore, embodiments of the invention provide an air wall type air conditioning unit which is convenient to install and transport.

It is to be noted that the design such as the modular structure of the air wall type air conditioning unit, the concrete structure of the heat exchanger 102, the connection structure between two adjacent refrigeration modules 100 and the drainage structure 117 of the invention is not limited to an air wall air conditioner, but can also be applied to other air conditioning products.

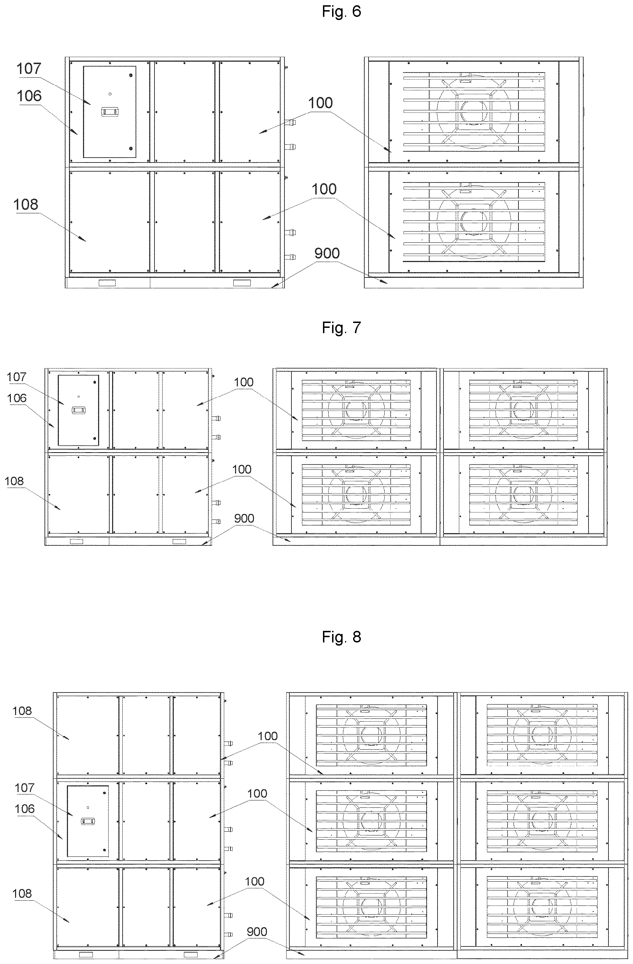

It is to be noted that Figs. 6 to 8 illustrate the schematic structure diagrams of another three embodiments of the air wall type air conditioning unit, in which Fig. 6 illustrates an embodiment in which the air wall type air conditioning unit includes two refrigeration modules 100, Fig. 7 illustrates an embodiment in which the air wall type air conditioning unit includes four refrigeration modules 100, and Fig. 8 illustrates an embodiment in which the air wall type air conditioning unit includes six refrigeration modules 100.

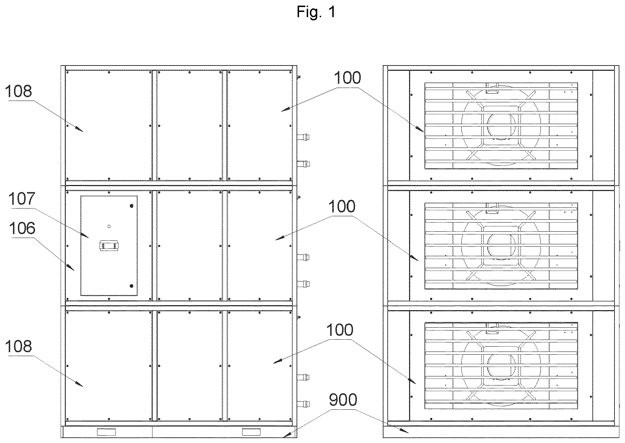

As shown in Figs. 1-3, the embodiments of the invention provide an air wall type air conditioning unit. The air wall type air conditioning unit includes a plurality of refrigeration modules 100 distributed in a vertical direction, each refrigeration module 100 includes: a housing 205, a heat exchanger 102 and a draught fan 104, where the housing 205 defines a cavity 206, and an air inlet 115 and an air outlet 116 are further disposed on the housing 205; the heat exchanger 102 is located in the cavity 206 and configured for cooling air; and the draught fan 104 is located in the cavity 206 and configured for conveying the cooled air to an equipment to be cooled; where, in a direction from the air inlet 115 to the air outlet 116, the heat exchanger 102 and the draught fan 104 are distributed in sequence.

In the above-mentioned technical solution, the three refrigeration modules 100 are detachably connected in the vertical direction, so that different numbers of refrigeration modules 100 and the number of draught fans in each refrigeration module 100 can be flexibly set according to the actual application scene (for example, as shown in Figs. 6 to 8, two, four or six refrigeration modules 100 can also be set), so that the air wall type air conditioning unit can be expanded vertically and horizontally, and meanwhile, the air wall type air conditioning unit is split into a plurality of refrigeration modules 100 with smaller volumes, which is convenient for transportation and handling. In the each refrigeration module 100, outside air enters into the cavity 206 through the air inlet 115 to exchange heat with the heat exchanger 102, and the draught fan 104 is able to provide driving force to blow the cooled air to the air outlet 116 and deliver it to the equipment to be cooled.

Through the above arrangement, the air wall type air conditioning unit is set to a modular structure, and each refrigeration module 100 is small in size, which is convenient for transportation and site installation, so that the construction period is shortened while ensuring the product quality; meanwhile, the modular design can make the parts miniaturized and batched, which is beneficial to batch processing of all parts and assembly of the whole machine.

In some embodiments, the draught fan 104 adopts a backward centrifugal fan, which has a large air volume, high efficiency and low noise, in this way, the draught fan 104 with a smaller size can meet the required air supply volume, thus reducing the size of the air wall type air conditioning unit.

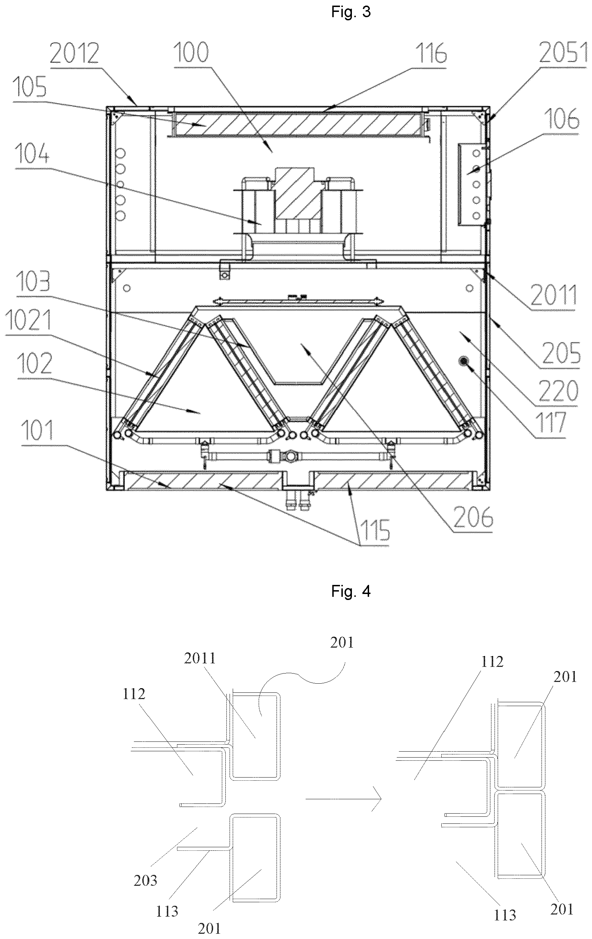

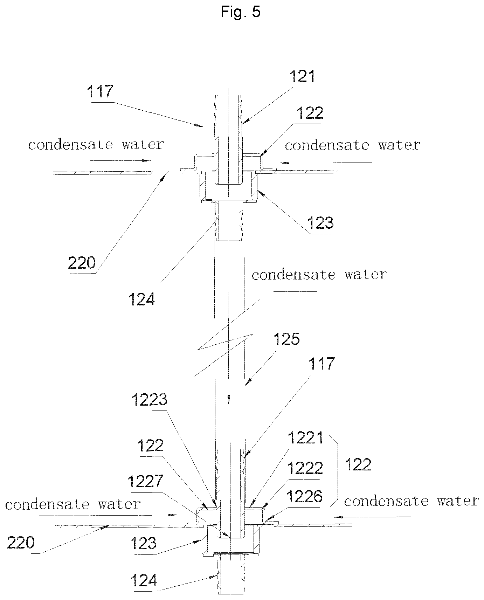

As shown in Figs. 3 and 5, in the embodiment of the invention, the each refrigeration module 100 further includes: a water pan 220 and a drainage structure 117, where the water pan 220 is located below the heat exchanger 102; and the drainage structure 117 is disposed in the cavity 206 and located on a side of the heat exchanger 102, the water pan 220 communicates with the drainage structure 117, and drainage structures 117 of two adjacent refrigeration modules 100 communicate through a connecting pipe 125.

In the above-mentioned technical solution, condensed water generated by the heat exchanger 102 during heat exchange with air is able to flow into the water pan 220, and the condensed water collected in the water pan 220 then flows into the drainage structure 117. Because the plurality of refrigeration modules 100 are distributed in the vertical direction, the condensed water generated by the plurality of refrigeration modules 100 can converge to a lowermost refrigeration module 100 through the drainage structure 117 and the connecting pipe 125 under the action of gravity, and be discharged out of the air wall type air conditioning unit.

With the above arrangement, a phenomenon that the condensed water accumulates or splashes on a surface of the heat exchanger 102 can be avoided, thus ensuring a stable refrigeration effect of the air wall type air conditioning unit. Meanwhile, the problem that a service life of the air wall type air conditioning unit is shortened due to the long-term accumulation of condensed water in the cavity 206 can also be avoided.

As shown in Figs. 3 and 5, in the embodiment of the invention, the water pan 220 is provided with a collecting groove 123. The drainage structure 117 includes: a first drainage pipe 121 and a second drainage pipe 124, the first drainage pipe 121 is connected with the water pan 220 and located above the water pan 220, and one end of the first drainage pipe 121 extends into the collecting groove 123; the second drainage pipe 124 communicates with the collecting groove 123; wherein, a second drainage pipe 124 of a refrigeration module 100 located above in two adjacent refrigeration modules 100 communicates with an end of the connecting pipe 125, and a first drainage pipe 121 of a refrigeration module 100 located below in the two adjacent refrigeration modules 100 communicates with the other end of the connecting pipe 125, so as to communicate two drainage structures 117 of the two adjacent refrigeration modules 100.

In the above technical solution, an upper end of the first drainage pipe 121 communicates with a drainage structure 117 of the refrigeration module 100 located above through the connecting pipe 125, and a lower end of the first drainage pipe 121 is located in the collecting groove 123 and not in contact with an inner wall face of the collecting groove 123, thus ensuring that the condensed water in the first drainage pipe 121 can smoothly flow into the collecting groove 123; meanwhile, the condensed water in the water pan 220 can also flow into the collecting groove 123, the upper end of the second drainage pipe 124 communicates with the bottom wall of the collecting groove 123, and a lower end of the second drainage pipe 124 communicates with a drainage structure 117 of the refrigeration module 100 located below.

With the above arrangement, the condensed water generated by the plurality of refrigeration modules 100 can converge to the bottom and discharged through the drainage structure 117 and the connecting pipe 125.

As shown in Figs. 3 and 5, in the embodiment of the invention, the drainage structure 117 further includes: a support piece 122, which includes a bottom plate 1221 and two side plates 1222 connected with the bottom plate 1221, an assembly through hole 1223 allowing the first drainage pipe 121 to pass through is formed in the bottom plate 1221, and the side plates 1222 are connected with the water pan 220.

In some embodiments, the support piece 122 further includes two connecting plates 1226 connected with the two side plates 1222, and the connecting plates 1226 and the bottom plate 1221 are respectively located on two sides of the side plates 1222.

In some embodiments, an included angle between the bottom plate 1221 and the side plate 1222 is 90 °, and an included angle between the connecting plate 1226 and the side plate 1222 is also 90 °, that is, the support piece122 forms a Q -shaped (similar to "Chinese character Ji") structure, and a middle of the Q - shaped structure forms an avoidance space 1227 for the condensed water in the water pan 220 to flow into the collecting groove 123.

Through the above arrangement, the connecting plate 1226 of the support piece 122 is connected with the water pan 220 through a locking piece, and the first drainage pipe 121 passes through the assembly through hole 1223 and is fixedly connected with the bottom plate 1221, so that the first drainage pipe 121 is connected with the water pan 220, and meanwhile, the condensed water in the water pan 220 can flow into the collecting groove 123.

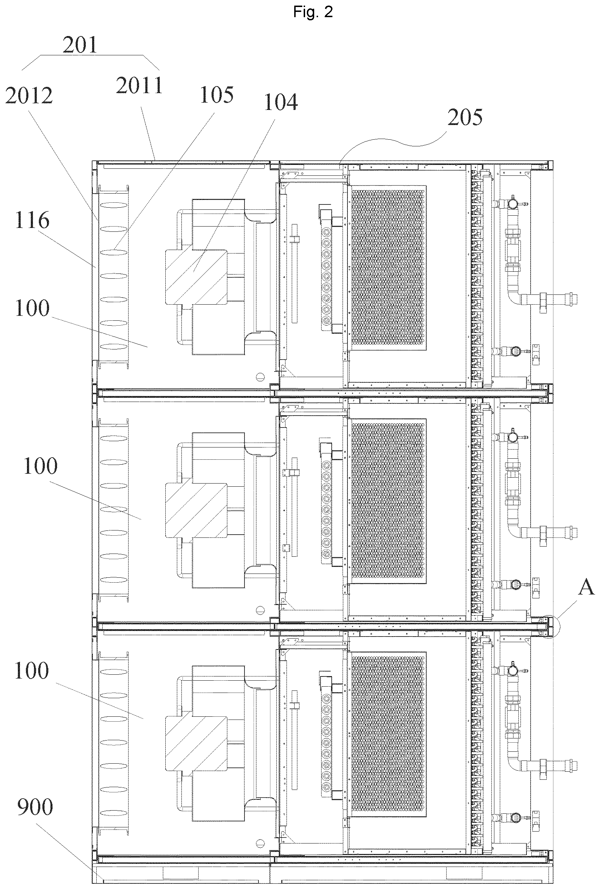

As shown in Figs. 2 to 4, in the embodiment of the invention, the housing 205 of the refrigeration module 100 is provided with a first side and a second side opposite to the first side, the first side is provided with a protrusion, and the second side is provided with a groove which is matched with the protrusion in a clamping manner, so that two adjacent refrigeration modules 100 are matched in a clamping manner.

It is to be noted that as shown in Fig. 2, a lower side of each refrigeration module 100 is the first side, and an upper side is the second side.

In the above-mentioned technical solution, the top of each refrigeration module 100 is provided with a groove, and the bottom of each refrigeration module 100 is provided with a protrusion, so that during installation, the protrusion at the bottom of the refrigeration module 100 located above falls into the groove at the top of the refrigeration module 100 located below to complete the installation, then a periphery and a middle of the refrigeration module 100 are connected and fixed by bolts, so that the plurality of refrigeration modules 100 can be locked, and the problems of front, back, left and right relative displacement and falling off among the plurality of refrigeration modules 100 can not occur.

Through the above arrangement, two adjacent refrigeration modules 100 are matched in a clamping manner by the protrusions and grooves, so that the plurality of refrigeration modules 100 can be stably connected, and the installed air wall type refrigeration module has better firmness and shock resistance, and is also convenient to locate during installation.

As shown in Figs. 2 to 4, in the embodiment of the invention, the housing 205 includes a supporting frame 201, a base 112 connected with the supporting frame 201, as well as a top cover 113 and circumferential side walls 108 connected with the supporting frame 201, the base 112 is disposed opposite to the top cover 113, a lower surface of the base 112 protrudes from a lower surface of the supporting frame 201 to form a protrusion, and the top cover 113 and the supporting frame 201 define a groove 203. When the air wall type air conditioning unit is assembled, the base 112 of the refrigeration module 100 located above in the adjacent two refrigeration modules 100 is placed in the groove 203 of the refrigeration module100 located below.

Through the above arrangement, two adjacent refrigeration modules 100 can be quickly installed through the clamping matching of the protrusions and grooves.

Specifically, the supporting frame 201 includes cross beams 2011 and longitudinal beams 2012 connected to each other. The supporting frame 201 includes two rectangular frames formed by end-to-end connection of four cross beams 2011, and four corners of the two rectangular frames are connected by four longitudinal beams 2012 extending in the vertical direction to form the supporting frame 201.

As shown in Figs. 1 and 3, in the embodiment of the invention, an inner wall face of the housing 205 is provided with an installation groove 2051 communicating with the cavity 206, and the refrigeration module 100 further includes an electric control box 106 located in the installation groove 2051, and a door plate 107 of the electric control box 106 is flush with the inner wall face of the housing 205.

In the above technical solution, the electric control box 106 can adopt standardized parts, so the electric control box 106 disposed in this way is universal and can be disposed at different positions on the housing 205, which is convenient for a user to adjust the position of the electric control box 106 according to the actual use requirements.

Through the above arrangement, the electric control box 106 can be embedded in the cavity 206, so that an external structure of the refrigeration module 100 is more attractive, and meanwhile, the door plate 107 is flush with the inner wall face of the housing 205, which is convenient for the user to operate.

Of course, in some other embodiments not shown by the drawings of the invention, according to the actual use requirements, the position of the electric control box 106 can also be set such that the door plate 107 protrudes from the outer wall of the housing 205.

As shown in Fig. 3, in the embodiment of the invention, the heat exchanger 102 includes a plurality of heat exchange tubes 1021 which communicate with each other, and the plurality of heat exchange tubes 1021 form a "W"-shaped structure.

In the above-mentioned technical solution, a side, with two second openings, of the "W"-shaped structure of the heat exchange tube 1021 faces the side where the air inlet 115 is located, and a side, with one first opening, of the "W"-shaped structure of the heat exchange tube 1021 faces the side where the draught fan 104 is located, so that the side, facing air to be cooled, of the heat exchange tube 1021 has a large contact area, and the air can fully exchange heat with the heat exchanger 102.

Through the above arrangement, the heat exchange tube 1021 with the "W"-shaped structure can increase a windward area of the heat exchanger 102, thus reducing a surface wind speed of the heat exchanger 102, making the surface wind speed less than 2m/s, reducing the resistance of the heat exchanger 102, and avoiding the problem that the condensed water generated on the surface of the heat exchanger 102 is brought into the machine room by the draught fan 104. Meanwhile, the lower wind speed can also reduce the static pressure of the draught fan 104, thus achieving the effect of improving the Energy Efficiency Ratio (EER) of the whole air wall type air conditioning unit. In addition, since the heat exchanger 102 provided in this way does not need to be provided with a plurality of rows of heat exchange tubes 1021, the power of the draught fan 104 can be reduced, thus achieving the effect of energy conservation.

Of course, in the embodiments not shown by the drawings of the invention, the plurality of heat exchange tubes 1021 may also be arranged in a "V" shape.

As shown in Fig. 3, in the embodiment of the invention, the each refrigeration module 100 further includes a flow equalizing plate 103 disposed between the heat exchanger 102 and the draught fan 104, the shape of the flow equalizing plate 103 is matched with at least part of the shape of the heat exchanger 102, and a plurality of evenly distributed through holes are formed on the flow equalizing plate 103.

In the above technical solution, the shape of the flow equalizing plate 103 is the same as that of a first opening (that is, the opening, facing the side where the draught fan 104 is located, of the heat exchanger 102) of the "W"-shaped structure of the heat exchanger 102 , so that the cooled air after heat exchange by the heat exchanger 102 can all pass through the flow equalizing plate 103, thus ensuring that the air outgoing of the draught fan is uniform, avoiding the problem that a local wind speed is too large or too small, and ensuring that the local temperature of the equipment to be cooled is not too high or low.

In some embodiments, the flow equalizing plate 103 is fixed between the heat exchanger 102 and the draught fan 104 in the form of uniformly distributed large-area meshes, so as to achieve uniform air velocity on the surface of the heat exchanger 102, avoid the problem that the local wind speed is too large or too small, and thus improve the heat exchange efficiency of the heat exchanger 102.

The air wall type air conditioning unit of the invention and the embodiments of the invention can be used in various occasions, such as computer rooms or data centers, the equipment to be cooled is a server, the air wall type air conditioning unit can be disposed against the wall, and the blowing direction corresponds to the server, so that the air wall type air conditioning unit not only occupies a small space, but also has high refrigerating capacity per unit area and high refrigerating efficiency.

As shown in Fig. 3, in the embodiment of the invention, the air wall type air conditioning unit further includes a foundation 900 capable of supporting the plurality of refrigeration modules. Each refrigeration module 100 further includes: an air valve 105 and an air filter 101, the air valve 105 is located at the air outlet 116, and can control the cavity 206 to be communicated or disconnected with the external environment; and the air filter 101 is located at the air inlet 115 to filter the incoming air.

In the above-mentioned technical solution, the air filter 101 is disposed at the air inlet 115 to facilitate cleaning and replacement; the filtration grade of the air filter 101 is not lower than G4 standard, which can ensure that the air is purified by air filter 101 and then cooled by heat exchanger 102, thus ensuring that the cooling air output by draught fan 104 can meet the use standard, and avoiding the problem of potential safety hazard caused by air pollution in the unit and data room.

In some embodiments, the air filter 101 adopts a large corrugated form, so that the air filter 101 provided in this way has a large filtering area and a small wind resistance, which can improve the filtering efficiency.

In addition, in the above-mentioned technical solution, when the refrigeration module 100 is started, a corresponding air valve 105 is opened to ensure that the refrigeration module 100 can normally output cooling gas; and when the refrigeration module 100 stops, the corresponding air valve 105 will be closed. In this way, each refrigeration module 100 forms airflow channel isolation, which can avoid the problem that the cold air in the data room enters the air inlet side of the draught fan 104 to cause airflow short circuit. Meanwhile, the plurality of refrigeration modules 100 can operate independently, so that the parts inside a certain refrigeration module 100 can be maintained or replaced without stopping the operation of the whole air wall type air conditioning unit.

In some embodiments, the air valve 105 is in the form that a plurality of blades are driven by an actuator. The main function of the air valve 105 is to open or close the air outlet 116. Therefore, any air valve 105 that can meet the above requirements is within the protection scope of this embodiment.

From the above description, it can be seen that the above embodiments of the invention achieve the following technical effects: in each refrigeration module, outside air enters into the cavity through the air inlet to exchange heat with the heat exchanger, and the draught fan can provide driving force to blow the cooled air to the air outlet and deliver it to the equipment to be cooled. The plurality of refrigeration modules are detachably connected in the vertical direction, so that different numbers of refrigeration modules can be disposed in the vertical direction according to actual needs; meanwhile, the air wall type air conditioning unit can be split into a plurality of refrigeration modules with smaller volumes, which is convenient for transportation and carrying, so that the construction period is shortened while ensuring the product quality; in addition, the modular design can make the parts miniaturized and batched, which is beneficial to batch processing of all parts and assembly of the whole machine. Condensate water produced by a plurality of refrigeration modules can converge to the bottom through the drainage structure and the connecting pipe and be discharged out of the air-conditioning unit, which can avoid the accumulation or splash of condensate water on the surface of the heat exchanger, thus ensuring the stable refrigeration effect of the air-conditioning unit. With the above arrangement, two adjacent refrigeration modules are matched in a clamping manner by the protrusions and grooves, so that the plurality of refrigeration modules can be stably connected, and the installed air wall type refrigeration module has better firmness and shock resistance, and is also convenient to locate during installation. The electric control box is embedded in the cavity, so that the external structure of the refrigeration module is more attractive, and meanwhile, the door plate is flush with the inner wall face of the housing, which is convenient for a user to operate. With the heat exchange of the "W"-shaped structure, the problem that the condensed water generated on the surface of the heat exchanger is brought into the machine room by the draught fan is avoided, and meanwhile, the power of the draught fan is reduced, thus achieving the effect of energy conservation.

The foregoing is merely some embodiments of the invention and is not intended to limit the invention, and various modifications and variations of the invention may be available for those skilled in the art. Any modification, equivalent replacement, improvement and the like made within the spirit and principle of the invention shall fall within the scope of protection of the invention.

## Claims

1. An air wall type air conditioning unit, comprising a plurality of refrigeration modules (100) distributed in a vertical direction, each refrigeration module (100) comprises:
a housing (205), which defines a cavity (206), and an air inlet (115) and an air outlet (116) are disposed on the housing (205);
a heat exchanger (102), located in the cavity (206), and the heat exchanger (102) is configured for cooling air; and
a draught fan (104), located in the cavity (206), and the draught fan (104) is configured for conveying cooled air to an equipment to be cooled;
wherein, in a direction from the air inlet (115) to the air outlet (116), the heat exchanger (102) and the draught fan (104) are distributed in sequence.

2. The air wall type air conditioning unit as claimed in claim 1, wherein the each refrigeration module (100) further comprises:
a water pan (220), which is located below the heat exchanger (102); and
a drainage structure (117), which is disposed in the cavity (206) and located on a side of the heat exchanger (102), the water pan (220) communicates with the drainage structure (117), and drainage structures (117) of two adjacent refrigeration modules (100) communicate through a connecting pipe (125).

3. The air wall type air conditioning unit as claimed in claim 2, wherein the water pan (220) is provided with a collecting groove (123), the drainage structure (117) comprises:
a first drainage pipe (121), connected with the water pan (220) and located above the water pan (220), and an end of the first drainage pipe (121) extends into the collecting groove (123); and
a second drainage pipe (124), which communicates with the collecting groove (123);
wherein, a second drainage pipe (124) of the refrigeration module (100) located above in the two adjacent refrigeration modules (100) communicates with an end of the connecting pipe (125), and a first drainage pipe (121) of the refrigeration module (100) located below in the two adjacent refrigeration modules (100) communicates with the other end of the connecting pipe (125), so as to communicate two drainage structures (117) of the two adjacent refrigeration modules (100).

4. The air wall type air conditioning unit as claimed in claim 3, wherein the drainage structure (117) further comprises:
a support piece (122), which comprises a bottom plate (1221) and two side plates (1222) connected with the bottom plate (122), an assembly through hole (1223) allowing the first drainage pipe (121) to pass through is formed in the bottom plate (1221), and the side plates (1222) are connected with the collecting groove (220).

5. The air wall type air conditioning unit of as claimed in any of claims 1-4, wherein the housing (205) of the each refrigeration module (100) is provided with a first side and a second side which are oppositely disposed, the first side is provided with a protrusion, and the second side is provided with a groove which is matched with the protrusion in a clamping manner, so that two adjacent refrigeration modules (100) are matched in a clamping manner.

6. The air wall type air conditioning unit as claimed in claim 5, wherein the housing (205) comprises a supporting frame (201), a base (112) connected with the supporting frame (201), a top cover (113) and circumferential side walls (108) connected with the supporting frame (201), the base (112) is disposed opposite to the top cover (113), a lower surface of the base (112) protrudes from a lower surface of the supporting frame (201) to form the protrusion, and the top cover (113) and the supporting frame (201) define the groove (203), when the air wall type air conditioning unit is assembled, a base (112) of a refrigeration module (100) located above in adjacent two refrigeration modules (100) is placed in a groove (203) of a refrigeration module (100) located below.

7. The air wall type air conditioning unit as claimed in any of claims 1-4, wherein an inner wall face of the housing (205) is provided with an installation groove (2051) communicating with the cavity (206), and the each refrigeration module (100) further comprises an electric control box (106) located in the installation groove (2051), and a door plate (107) of the electric control box (106) is flush with the inner wall face of the housing (205).

8. The air wall type air conditioning unit as claimed in any of claims 1-4, wherein the heat exchanger (102) comprises a plurality of heat exchange tubes (1021) which communicate with each other, and the plurality of heat exchange tubes (1021) form a "W"-shaped structure; or, the plurality of heat exchange tubes (1021) form a "V" shape.

9. The air wall type air conditioning unit as claimed in any of claims 1-4, wherein each refrigeration module (100) further comprises a flow equalizing plate (103) disposed between the heat exchanger (102) and the draught fan (104), a shape of the flow equalizing plate (103) is matched with at least part of a shape of the heat exchanger (102), and a plurality of through holes are formed in the flow equalizing plate (103) and the through holes are evenly distributed.

10. The air wall type air conditioning unit as claimed in any of claims 1-4, wherein the air wall type air conditioning unit further comprises a foundation (900) capable of supporting the plurality of refrigeration modules (100), and the each refrigeration module (100) further comprises:
an air valve (105), which is located at the air outlet (116), and the air valve (105) is able to control the cavity (206) to be communicated or disconnected with the external environment; and
an air filter (101), which is located at the air inlet (115) to filter incoming air.
